# EUROPEAN PATENT APPLICATION

(11) **EP 3 235 840 A1**
(43) Date of publication of application: **25.10.2017**
(21) Application number: 15869167.5
(22) Date of filing: 20.11.2015
(51) Int. Cl.: C08F 220/60, C08F 220/06, C08F 220/32, C08F 216/14, C09B 69/10, G03F 7/004, G03F 7/027, G02B 5/20

(54) **DYE COMPOUND AND PREPARATION METHOD THEREFOR, COLORANT, PHOTOSENSITIVE RESIN COMPOSITION AND LIGHT FILTER**

(30) Priority: 15.12.2014 CN 201410778695
(71) Applicant: BOE Technology Group Co., Ltd., Beijing 100015 (CN)
(72) Inventor: XIN, Yangyang, Beijing 100176 (CN); WANG, Xuelan, Beijing 100176 (CN); LI, Lin, Beijing 100176 (CN); ZHAO, Ming, Beijing 100176 (CN)
(74) Representative: Cohausz & Florack
(86) International application number: PCT/CN2015/095127
(87) International publication number: WO 2016/095659

(57) **Abstract**

The present invention provides a dye compound and a method for preparing the same, a colorant, a photosensitive resin composition and an optical filter. As the dye compound of the present invention has an epoxy group, the dye compound can effectively prevent surface shrinkage of an optical filter while improving transmittance thereof.

## Description

### FIELD OF THE INVENTION

The present invention relates to the technical field of display, and specifically relates to a dye compound and a method for preparing the same, and a colorant, a photosensitive resin composition and an optical filter including the dye compound.

### BACKGROUND OF THE INVENTION

In recent years, as for color filters used in liquid crystal displays, the requirements on the transmittance (i.e., luminance) and the reliability are improved.

A method for manufacturing color filters includes a pigment dispersion method, a printing method, an electrodeposition method and an inkjet method and the like, wherein a pigment is used as a colorant; and a dyeing method and a dye dispersion method, wherein a dye or a salt-forming dye is used as a colorant.

Typically, pigments with excellent heat resistance and light resistance are used as colorants of an optical filter. In term of the perspective of the precision and the stability of the forming method, the pigment dispersion method is often used. However, the transmittance of the existing optical filter employing a pigment as a colorant is relatively low. Moreover, an optical filter is generally prepared by radical polymerization of polymerizable monomers; however, the polymerization of the monomers will lead to surface shrinkage of the optical filter.

### SUMMARY OF THE INVENTION

The object of the present invention is to solve the problems of surface shrinkage and relatively low transmittance of an optical filter which employs pigment as a colorant in the prior art, and provide a dye compound, which has high transmittance and reduces the shrinkage, a method for preparing the same, a colorant, a photosensitive resin composition and an optical filter.

The dye compound provided by the present invention includes a repeat unit shown by Formula 1, a repeat unit shown by Formula 2 and a repeat unit from an olefinic unsaturated monomer having an epoxy functional group;
wherein, the structures of the repeat units shown by the formula 1 and the formula 2 are expressed as follows: 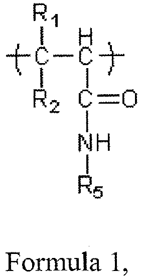 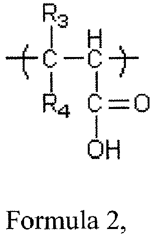 wherein, R₁, R₂, R₃, R₄ and R₅ each independently represent a hydrogen atom; or a straight-chain alkyl, a branched chain alkyl, a cycloalkyl or an aryl having 1-12 carbon atoms, and the dye compound has a molecular weight of 5000-20000.

Preferably, the olefinic unsaturated monomer having an epoxy functional group includes one or more of glycidyl methacrylate, glycidyl acrylate and allyl glycidyl ether.

Preferably, the dye compound has a molecular weight of 8000-12000.

The present invention further provides a method for preparing the aforementioned dye compound, including the following steps:
1) Preparing an amide compound
   reacting an olefmic unsaturated monomer having acyl chloride with an alkaline dye having an amino to obtain the amide compound, by which the alkaline dye having an amino is connected with olefinic unsaturated double bonds for forming a polymer; and
2) Copolymerization
   The obtained amide compound, an olefinic unsaturated monomer having an epoxy functional group and an olefinic unsaturated monomer having at least one carboxyl or carboxylic acid anhydride group carrying out copolymerization in a solvent to give the dye compound.

Preferably, in the step of preparing an amide compound, a weight ratio of the alkaline dye having an amino to the olefinic unsaturated monomer having acyl chloride is (0.5-4):1.

Preferably, in the step of preparing the amide compound, reaction time is 2-5h, and reaction temperature is 0-20°C.

Preferably, in the copolymerizing step, a weight ratio of the amide compound, the olefinic unsaturated monomer having at least one carboxyl or carboxylic acid anhydride group, the olefinic unsaturated monomer having an epoxy functional group, and the solvent is (2-6):(1-5):(1-5):(15-25).

Preferably, in the copolymerizing step, a ratio of an initiator for copolymerization to the sum of the olefinic unsaturated monomer having an epoxy functional group and the olefinic unsaturated monomer having at least one carboxyl or carboxylic acid anhydride group is 0.5-5%.

Preferably, in the copolymerizing step, reaction temperature of copolymerization is 95-105 °C, and reaction time is 1-5h.

Preferably, the olefinic unsaturated monomer having acyl chloride includes one or more of acryloyl chloride, methacryloyl chloride, N-hydroxyethyl acryloyl chloride or N-hydroxyethyl methacryloyl chloride.

Preferably, the alkaline dye having an amino includes one or more of basic blue 11, basic blue 17, basic blue 26, basic red 9, basic red 2 and basic violet 2.

Preferably, the olefinic unsaturated monomer having an epoxy functional group includes one or more of glycidyl methacrylate, glycidyl acrylate and allyl glycidyl ether.

Preferably, the olefinic unsaturated monomer having at least one carboxyl or carboxylic acid anhydride group includes: a monocarboxylic acid having a vinyl group and an anhydride thereof, a dicarboxylic acid having a vinyl group and an anhydride thereof, a polycarboxylic acid having a vinyl group and an anhydride thereof. Preferably, the monocarboxylic acid having a vinyl group and the anhydride thereof include any one of acrylic acid, methacrylic acid, crotonic acid, α-chloroacrylic acid, cinnamic acid, and anhydrides thereof.

The dicarboxylic acid having a vinyl group includes any one of maleic acid, fumaric acid, itaconic acid, the citraconic acid, and anhydrides thereof.

The present invention further provides a colorant comprising the aforementioned dye compound.

Preferably, the colorant includes: 5-50 parts by weight (pbw) of the dye compound, preferably 10-30 parts by weight; and 5-50 parts by weight of pigment, preferably 10-30 parts by weight.

The present invention further provides a photosensitive resin composition including the aforementioned dye compound.

Preferably, the photosensitive resin composition further includes a pigment dispersion.

The pigment dispersion is used for dyeing, and in general can only be used after dispersion, and dispersants can employ commercially available dispersants.

Preferably, the photosensitive resin composition includes:
5-50 parts by weight of a dye compound;
5-50 parts by weight of a pigment dispersion;
5-60 parts by weight of an alkaline soluble resin;
5-60 parts by weight of a polymerizable monomer;
0.1-10 parts by weight of a photopolymerization initiator; and
100-3000 parts by weight of a solvent.

The present invention further provides an optical filter prepared from the aforementioned photosensitive resin composition.

The epoxy group in the dye compound of the present invention can perform cationic polymerization, and perform an addition reaction with the carboxyl; and moreover, the ring-opening polymerization of the epoxy group and the addition reaction of the epoxy group with the carboxyl would not result shrinkage. Therefore, when the optical filter is prepared from the photosensitive resin composition comprising the dye compound of the present invention, the shrinkage of the optical filter can be effectively reduced, so the surface shrinkage of the optical filter can be effectively prevented, while improved transmittance is obtained.

### BRIEF DESCRIPTION OF THE DRAWINGS

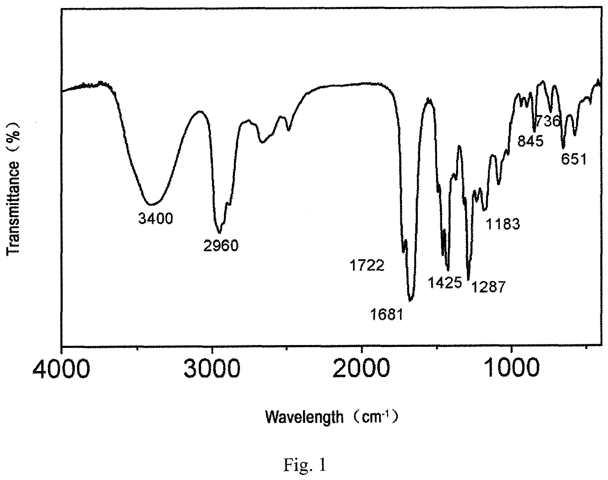

Fig.1 is an infrared spectrum of a dye compound a1 according to an embodiment 1 of the present invention.

### DESCRIPTION OF THE PREFERRED EMBODIMENT

In order that those skilled in the art can better understand the technical solutions of the present invention, a further detailed description of the present invention will be given below in combination with the accompany drawings and specific embodiments.

The present invention provides a dye compound, including a repeat unit shown by Formula 1, a repeat unit shown by Formula 2 and a repeat unit from an olefinic unsaturated monomer having an epoxy functional group;
wherein, the structures of the repeat units shown by Formula 1 and Formula 2 are expressed as follows: 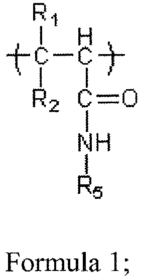 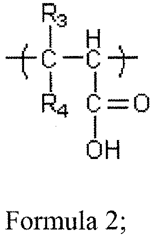 wherein, R₁, R₂, R₃, R₄ and R₅ each independently represent a hydrogen atom; or a straight-chain alkyl, a branched chain alkyl, a cycloalkyl or an aryl having 1-12 carbon atoms; and the molecular weight of the dye compound is 5000-20000. The groups represented by R₁-R₅ can be optionally substituted by an alkyl or a halogen.

The epoxy group in the dye compound of the present invention can perform cationic polymerization, and perform an addition reaction with the carboxyl; and moreover, the ring-opening polymerization of the epoxy group and the addition reaction of the epoxy group with the carboxyl would not result shrinkage. Therefore, the shrinkage of an optical filter can be effectively reduced or avoided.

Preferably, the olefinic unsaturated monomer having an epoxy functional group includes one or more of glycidyl methacrylate, glycidyl acrylate and allyl glycidyl ether.

Preferably, the dye compound has a molecular weight of 8000-12000.

The present invention further provides a method for preparing the aforementioned dye compound, including the following steps:

### [Solution 1]

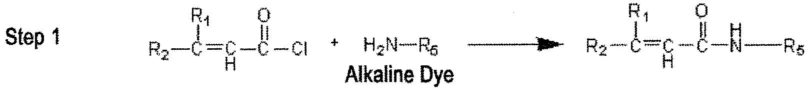

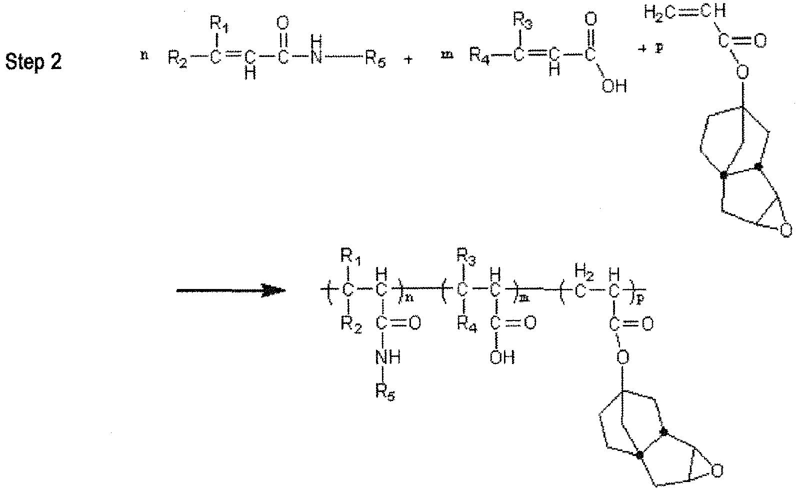

1) Preparing an amide compound
   reacting an olefinic unsaturated monomer having acyl chloride with an alkaline dye having an amino to obtain the amide compound, by which the alkaline dye having an amino is connected with olefinic unsaturated double bonds for forming a polymer; and
2) Copolymerization
   the obtained amide compound, an olefinic unsaturated monomer having an epoxy functional group and an olefinic unsaturated monomer having at least one carboxyl or carboxylic acid anhydride group carrying out copolymerization in a solvent to give the dye compound.

When the dye compound comprising the olefinic unsaturated monomer having at least one carboxyl or carboxylic acid anhydride group is used in a photosensitive resin composition , and, the carboxyl or the carboxylic acid anhydride group reacts with lye, in a lye development process, result an improved alkaline solubility.

Preferably, in the step of preparing an amide compound, a weight ratio of the alkaline dye having an amino to the olefinic unsaturated monomer having acyl chloride is (0.5-4):1.

Preferably, in the step of preparing an amide compound, reaction time is 2-5h, and reaction temperature is 0-20°C.

Preferably, in the step of copolymerization, a weight ratio of the amide compound, the olefinic unsaturated monomer having at least one carboxyl or carboxylic acid anhydride group, the olefinic unsaturated monomer having an epoxy functional group to the solvent is (2-6):(1-5):(1-5):(15-25).

The solvent includes any one of ethylene glycol monomethylether, propylene glycol monomethyl ether, propylene glycol methyl ether acetate (PMA) and 3-ethoxy ethyl propionate.

A copolymerization initiator includes 2,2'-azobisisobutyronitrile and other azo compounds, benzoyl peroxide and other peroxide compounds.

Preferably, in the step of copolymerization, a ratio of the initiator of the copolymerization to the sum of the olefinic unsaturated monomer having an epoxy functional group and the olefinic unsaturated monomer having at least one carboxyl or carboxylic acid anhydride group is 0.5-5%.

Preferably, in the step of copolymerization, reaction temperature of the copolymerization is 95-105°C, and reaction time is 1-5h.

Preferably, the olefinic unsaturated monomer having acyl chloride includes one or more of acryloyl chloride, methacryloyl chloride, N-hydroxyethyl acryloyl chloride or N-hydroxyethyl methacryloyl chloride.

The alkaline dye having an amino can be azos, anthraquinones, triarylmethanes, xanthenes and phthalocyanines, and other alkaline dyes having aminos.

Preferably, the alkaline dye having an amino includes one or more of basic blue 11, basic blue 17, basic blue 26, basic red 9, basic red 2 and basic violet 2.

Preferably, the olefinic unsaturated monomer having an epoxy functional group includes one or more of glycidyl methacrylate, glycidyl acrylate and allyl glycidyl ether.

Preferably, the olefinic unsaturated monomer having at least one carboxyl or carboxylic acid anhydride group includes a monocarboxylic acid having a vinyl group and an anhydride thereof, a dicarboxylic acid having a vinyl group and an anhydride thereof, a polycarboxylic acid having a vinyl group and an anhydride thereof.

Preferably, the monocarboxylic acid having a vinyl group and the anhydride thereof include any one of acrylic acid, methacrylic acid, crotonic acid, α-chloroacrylic acid, cinnamic acid, and anhydrides thereof.

The dicarboxylic acid having a vinyl group includes any one of maleic acid, fumaric acid, itaconic acid, citraconic acid, and anhydrides thereof.

The present invention further provides a colorant comprising the aforementioned dye compound.

Preferably, the colorant includes: 5-50 parts by weight of dye compound, preferably 10-30 parts by weight; and 5-50 parts by weight of pigment, preferably 10-30 parts by weight.

The present invention further provides a photosensitive resin composition comprising the aforementioned dye compound.

Preferably, the photosensitive resin composition further comprises a pigment dispersion. The pigment dispersion includes pigment and a dispersant.

The pigment may include phthalocyanines, anthraquinones, azos and the like. Specifically it includes red pigment mainly including perylene series, quinacridone and diketopyrrolopyrrole series, such as P.R.224, P.R.254, P.R.255, P.R.264, P.R.122, P.R.123, P.R.177, P.R.179, P.R.190, P.R.202, P.R.210, P.R.270, P.R.272, P.R.122 or the like; blue pigment, such as P.B.1, P.B.2, P.B.15, P.B.15:3, P.B.15:4, P.B.15:6, P.B.16, P.B.22, P.B.60, P.B.66 or the like; purple pigment, such as P.V.32, P.V.36, P.V.38, P.V.39, P.V.23, P.V.9, P.V.1 or the like; and yellow pigment like azos and heterocycles, such as P.Y.1, P.Y12, P.Y.3, P.Y.13, P.Y.83, P.Y.93, P.Y.94, P.Y.95, P.Y.109, P.Y.126, P.Y.127, P.Y.138, P.Y.139, P.Y.147, P.Y.150, P.Y.174 or the like.

The above pigments used for dyeing generally applied after being dispersed, and the dispersant can be any commercially available dispersant.

Preferably, the photosensitive resin composition comprises:
5-50 parts by weight of dye compound, preferably 10-30 parts by weight,
5-50 parts by weight of pigment dispersion, preferably 10-30 parts by weight;
5-60 parts by weight of alkaline soluble resin, preferably 10-30 parts by weight;
5-60 parts by weight of polymerizable monomers, preferably 10-30 parts by weight;
0.1-10 parts by weight of photopolymerization initiator, preferably 0.5-5 parts by weight; and
100-3000 parts by weight of solvent, preferably 500-2000 parts by weight.

The present invention further provides an optical filter, which is prepared from the aforementioned photosensitive resin composition.

The alkaline soluble resin is selected from (methyl) acrylic resin and can be a copolymer of (methyl) acrylic acid, (methyl) acrylate and other compounds having double bonds. For example, products chemically made of Nippon steel and with trade names V259ME and V301ME. The alkaline soluble resin has a carboxyl, which can be dissolved in a developing solution and primarily play a development function.

The polymerizable monomers can be acrylate monomers, such as pentaerythritol triacrylate, dipentaerythritol triacrylate, pentaerythritol tetraacrylate, dipentaerythritol tetraacrylate, dipentaerythritol pentaacrylate, dipentaerythritol hexaacrylate (DPHA) and the like. The double bonds in the polymerizable monomer can be initiated by the initiator to polymerize under illumination, and thus the solubility of the film is changed by the polymerization, i.e. the double bonds in the illuminated part are polymerized, thus cannot be dissolved in the lye (the developing solution), whereas the non-illuminated part can be dissolved in the lye.

The photopolymerization initiator can be one of diimidazole compounds, benzoin compounds, polynuclear quinone compounds, benzoin compounds, benzophenone compounds, acetophenone compounds, triazine compounds, diazo compounds, xanthone compounds, oxime ester compounds, iodonium salt and sulfonium salt, or the combination thereof, for example, N-benzoyloxy-1-(4-phenylthiophenyl) octane-1-ketone-2-imine (OXE01). The photopolymerization initiator can initiate the polymerization of the polymerizable monomers.

Preferably, the photosensitive resin composition of the present invention includes a solvent and is mixed into a liquid composition. The solvent should disperse or dissolve the components of the photosensitive resin composition, does not react with these components and has moderate volatility. These solvents can be propylene glycol methyl ether acetate, cyclohexanone, propylene glycol monomethyl ether, diethylene glycol diethyl ether, 3-ethyl ethoxypropionate and the like, and these solvents can be used separately or in any combination of two or more.

Besides the colorant, the alkaline soluble resin, the monomers and the initiator, the photosensitive resin composition of the present invention can also contain other additives if necessary, for example, surfactants, such as nonionic, cationic, anionic surfactants and the like; adhesion promoters, such as vinyl trimethoxy silane, 3-mercaptopropyl trimethoxysilane and the like; antioxidants, such as and 2,6-di-tert-butylphenol and the like.

The present invention will be described below in detail by the examples, so that those skilled in the art can understand the technical features and beneficial effects of the present invention more clearly.

### Example 1

A dye compound a1 is provided in this example, wherein the structure of a repeat unit thereof is expressed as follows: 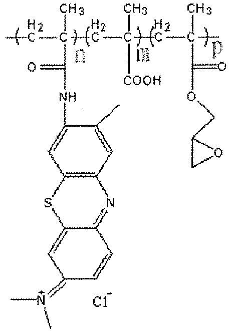 wherein, n, m and p are integers larger than 1; and the dye compound has a molecular weight of 8000.

The dye compound a1 is prepared according to a solution 2:

### [Solution 2]

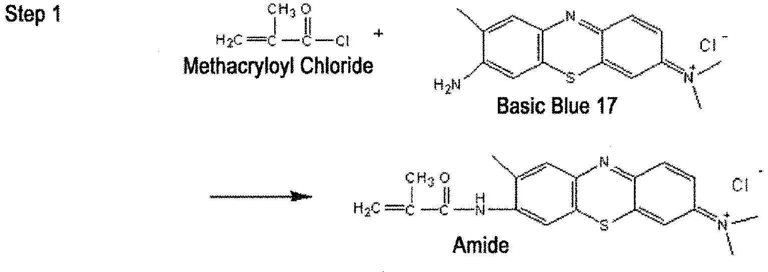

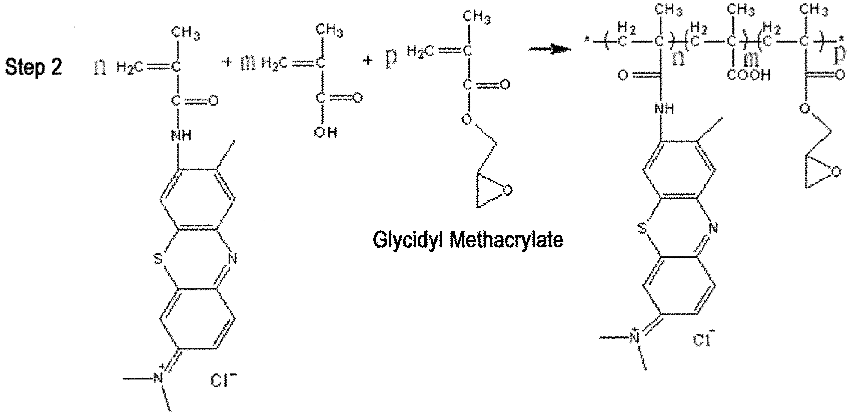

### 1) Preparing an amide compound

50 parts by weight of triethylamine is added in a three-necked flask containing 30 parts by weight of methacryloyl chloride to serve as a solvent, then 20 parts by weight of basic blue 17 is added, a reaction is carried out for 3h at 10°C, and then filtering and rotary evaporation are carried out to obtain the amide compound.

### 2) Copolymerization

A nitrogen inlet, a mixer, a heater, a condenser pipe and a thermometer are arranged on a four-opening conical flask with a volume of 1000ml, nitrogen is imported, and 40 parts by weight of the amide compound, 30 parts by weight of methacrylic acid monomers, 30 parts by weight of glycidyl methacrylate monomers and 200 parts by weight of 3-ethyl ethoxypropionate (EEP) serving as a solvent are added at one time.

While stirring, the temperature of the conical flask is raised to 100°C by employing an oil bath, then 3 parts by weight of 2,2'-azobis-2-methylbutyronitrile serving as a polymerization initiator is dissolved in organic solvent EEP, and then is added into the conical flask within an equal interval of 1h in 5 equal parts.

The reaction temperature in polymerization is kept at 100°C, and the polymerization is carried out for 5h. After the polymerization is completed, 200 parts by weight of toluene is added in the polymer solution, stirring and washing are carried out to separate out a polymer, and the polymeric dye compound a1 is obtained by centrifugal filtration.

Infrared spectrum analysis is carried out on the obtained polymeric dye compound a1, and the result is as shown in Fig.1. It can be seen from Fig.1 that the peak with a wavelength of 2960 is an absorption peak of a long chain alkyl is at a, the peak with a wavelength of 1722 is an absorption peak of an ester carbonyl, the peak with a wavelength of 1681 is an absorption peak of an amide carbonyl (which indicates that an amide bond is formed), and the peak with a wavelength of 1100 is an absorption peak of an ether bond (epoxy), which indicates that the polymeric compound a1 having the ether bond is synthesized in this example.

### Example 2

A dye compound a2 is provided in this example, wherein the structure of a repeat unit thereof is expressed as follows: 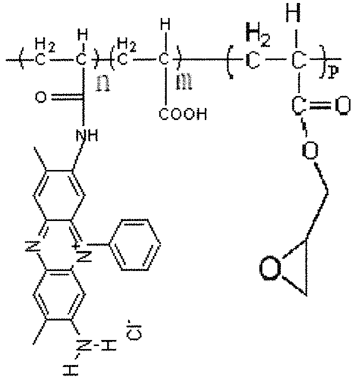 wherein, n, m and p are integers larger than 1; and the dye compound has a molecular weight of 12000.

Similar to the solution 2, the preparation steps of the dye compound a2 are as follows:

### 1) Preparing an amide compound

50 parts by weight of triethylamine is added in a three-necked flask containing 20 parts by weight of acryloyl chloride to serve as a solvent, then 20 parts by weight of basic red 2 is added, a reaction is carried out for 2h at 2°C, and then filtering and rotary evaporation are carried out to obtain the amide compound.

### 2) Copolymerization

A nitrogen inlet, a mixer, a heater, a condenser pipe and a thermometer are arranged on a four-opening conical flask with a volume of 1000ml, nitrogen is imported, and 60 parts by weight of the amide compound, 20 parts by weight of acrylic acid, 20 parts by weight of glycidyl methacrylate monomers and 200 parts by weight of 3-ethyl ethoxypropionate (EEP) serving as a solvent are added at one time.

While stirring, the temperature of the conical flask is raised to 95°C by employing an oil bath, then 2 parts by weight of 2,2'-azobis-2-methylbutyronitrile serving as a polymerization initiator is dissolved in organic solvent EEP, and then is added into the conical flask within an equal interval of 1h in 5 equal parts.

The reaction temperature in polymerization is kept at 95°C, and the polymerization is carried out for 3h. After the polymerization is completed, 200 parts by weight of toluene is added into the polymer solution, stirring and washing are carried out to separate out a polymer, and the polymeric dye compound a2 is obtained by centrifugal filtration.

Infrared spectrum analysis is carried out on the obtained polymeric dye compound a2, and a result similar to that in Fig.1 is obtained, which indicates that the polymeric compound a2 having an ether bond is synthesized in this example.

### Example 3

A dye compound a3 is provided in this example, wherein the structure of a repeat unit thereof is expressed as follows:

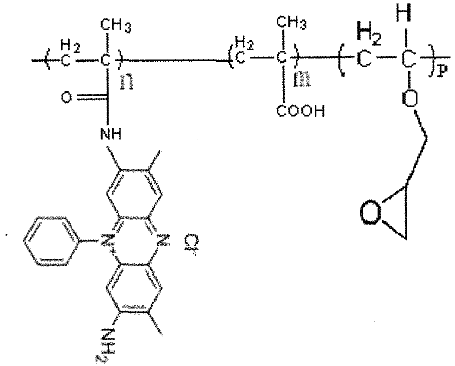

wherein, n, m and p are integers larger than 1; and the dye compound has a molecular weight of 5000.

Similar to the solution 2, the preparation steps of the dye compound a3 are as follows:

### 1) Preparing an amide compound

50 parts by weight of triethylamine is added in a three-necked flask containing 10 parts by weight of acryloyl chloride to serve as a solvent, then 40 parts by weight of basic red 2 is added, a reaction is carried out for 5h at 20°C, and then filtering and rotary evaporation are carried out to obtain the amide compound.

### 2) Copolymerization

A nitrogen inlet, a mixer, a heater, a condenser pipe and a thermometer are arranged on a four-opening conical flask with a volume of 1000ml, nitrogen is imported, and 20 parts by weight of the amide compound, 40 parts by weight of methacrylic acid, 40 parts by weight of glycidyl methacrylate and 200 parts by weight of 3-ethyl ethoxypropionate (EEP) serving as a solvent are added at one time.

While stirring, the temperature of the conical flask is raised to 105°C by employing an oil bath, then 0.4 parts by weight of dibenzoyl peroxide serving as a polymerization initiator is dissolved in organic solvent EEP, and then is added into the conical flask within an equal interval of 1h in 5 equal parts.

The reaction temperature in polymerization is kept at 105°C, and the polymerization is carried out for 1h. After the polymerization is completed, 200 parts by weight of toluene is added into the polymer solution, stirring and washing are carried out to separate out a polymer, and the polymeric dye compound a3 is obtained by centrifugal filtration.

Infrared spectrum analysis is carried out on the obtained polymeric dye compound a3, and a result similar to that in Fig.1 is obtained, which indicates that the polymeric compound a3 having an ether bond is synthesized in the embodiment.

### Example 4

A dye compound a4 is provided, wherein the structure of a repeat unit thereof is expressed as follows: 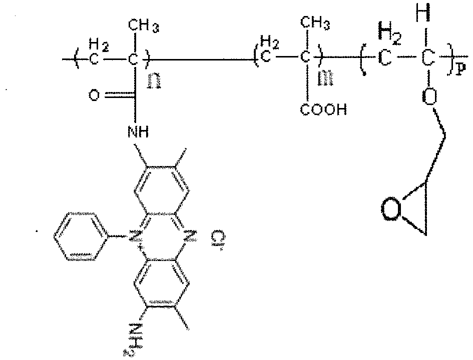 wherein, n, m and p are integers larger than 1; and the dye compound has a molecular weight of 20000.

Similar to the solution 2, the preparation steps of the dye compound a4 are as follows:

### 1) Preparing an amide compound

50 parts by weight of triethylamine is added in a three-necked flask containing 10 parts by weight of acryloyl chloride to serve as a solvent, then 40 parts by weight of basic red 2 is added, a reaction is carried out for 5h at 20°C, and then filtering and rotary evaporation are carried out to obtain the amide compound.

### 2) Copolymerization

A nitrogen inlet, a mixer, a heater, a condenser pipe and a thermometer are arranged on a four-opening conical flask with a volume of 1000ml, nitrogen is imported, and 20 parts by weight of the amide compound, 40 parts by weight of methacrylic acid, 40 parts by weight of glycidyl methacrylate and 200 parts by weight of 3-ethyl ethoxypropionate (EEP) serving as a solvent are added at one time.

While stirring, the temperature of the conical flask is raised to 105°C by employing an oil bath, then 0.4 parts by weight of dibenzoyl peroxide serving as a polymerization initiator is dissolved in organic solvent EEP, and then is added into the conical flask within an equal interval of 1h in 5 equal parts.

The reaction temperature in polymerization is kept at 105°C, and the polymerization is carried out for 2h. After the polymerization is completed, 200 parts by weight of toluene is added into the polymer solution, stirring and washing are carried out to separate out a polymer, and the polymeric dye compound a4 is obtained by centrifugal filtration.

Infrared spectrum analysis is carried out on the obtained polymeric dye compound a4, and a result similar to that in Fig.1 is obtained, which indicates that the macromolecular compound a4 having an ether bond is synthesized in the embodiment.

### Examples 5-12 and Comparative Examples 1-2

According to the components and amounts in table 1, a magnetic stirrer is used for stirring for 2h to uniformly mix the components, so as to respectively prepare the photosensitive resin compositions in the examples 5-12(Ex. 5-12) and the comparative examples 1-2(C. Ex. 1-2).

The amounts of the components in table 1 are all parts by weight (pbw), wherein the amounts of pigment dispersions PM-1, PM-2 and PM-3 are counted by the parts by weight of solid substance.

**Table 1 Composition of the Photosensitive Resin Compositions in Examples and Comparative Examples**

| | C. Ex.1 | C. Ex. 2 | Ex. 6 | Ex. 7 | Ex. 8 | Ex. 9 | Ex. 10 | Ex. 11 | Ex.12 | Ex.13 |
|---|---|---|---|---|---|---|---|---|---|---|
| Alkaline soluble resin B1 | 20 | 20 | 20 | 20 | 20 | 10 | 30 | 20 | 5 | 50 |
| DPHA | 20 | 20 | 20 | 20 | 20 | 30 | 10 | 20 | 60 | 5 |
| OXE01 | 5 | 5 | 5 | 5 | 5 | 0.5 | 3 | 4 | 10 | 0.1 |
| Dye compound | -- | -- | a1,20 | a2,20 | a3,20 | a1,10 | a3,30 | a4,10 | a4,5 | a4,50 |
| Blue pigment P.B.15:6 | -- | 15 | -- | -- | -- | -- | -- | -- | -- | -- |
| PM-1 | 13 | -- | -- | 12 | 12 | -- | 7 | 27 | 47 | 4 |
| PM-2 | 14 | | | | | | | | | |
| PM-3 | 3 | | | 3 | 3 | | 3 | 3 | 3 | 1 |
| PMA | 1000 | 100 | 1000 | 1000 | 1000 | 100 | 2000 | 500 | 3000 | 1000 |

The pigment dispersions are prepared by the following method according to the composition in table 2:
uniformly stirring and mixing the components in table 2, dispersing for 5h in a grinding machine (Waldorf Po DYNO-MILL RESEARCH LAB) by using zirconium oxide beads with a diameter of 0.5mm, and then filtering by using a 5.0µm filter to obtain the pigment dispersions PM-1, PM-2 and PM-3.

**Table 2 components and contents in the pigment dispersions**

| Pigment dispersion | Pigment powder | Acrylic resin | Resin dispersant | Solvent |
|---|---|---|---|---|
| PM-1 | C.I. pigment red 254 15 pbw | ACAZ251 5 pbw | EFKA4300 3 pbw | Propylene glycol methyl ether acetate 77 pbw |
| PM-2 | C.I. pigment red 177 15 pbw | ACA Z251 5 pbw | EFKA4300 3 pbw | Propylene glycol methyl ether acetate 77 pbw |
| PM-3 | C.I. pigment yellow 150 15 pbw | ACA Z251 5 pbw | EFKA4300 3 pbw | Propylene glycol methyl ether acetate 77 pbw |

The photosensitive resin compositions obtained in the examples and the comparative examples are respectively coated on a 10cm*10cm glass substrate to obtain an approximate 3µm thick coating film, the coating film is pre-roasted at 90°C for 100s, then the coating film is irradiated by ultraviolet (an exposure machine canon PLA-501F) at illuminance of 50mj/cm², the coating film is immersed in a KOH developing solution with a temperature of 23°C and a concentration of 0.042wt% for developing for 2min, then the coating film is cleaned by pure water and is roasted at 230°C for 30min, so as to form a photosensitive resin layer on the glass substrate as an optical filter.

The properties of the obtained optical filter are evaluated by the following method:

### 1. Sensitivity

A pattern with a minimum precision of 3µm is irradiated by 365nm ultraviolet with intensity of 10mW/cm², and then is developed for 40s in 0.042wt% KOH aqueous solution at 23°C. After developing completed, the pattern is washed by pure water for 1min.

### 2. Resolution

The minimum size of a pattern film formed in the sensitivity test is measured.

### 3. Transmittance

The transmittance of the pattern film at 400nm is measured by using a spectrophotometer.

### 4. Surface shrinkage

The obtained optical filter is irradiated by 150 mj/cm² ultraviolet by using a high pressure mercury lamp, then whether a micropore is generated on the surface is observed by using a scanning electron microscope (SEM). If no micropore is generated on the surface, it indicates no shrinkage, and then the optical filter is marked as "○"; if a few of micropores are generated on the surface, it indicates little shrinkage, and then the optical filter is marked as "Δ"; and if there are numerous micropores on the surface, it indicates serious shrinkage, and then the optical filter is marked as "×".

Performance test results of the optical filters prepared from the photosensitive resin compositions in the examples 5-12 and the comparative examples 1-2 are expressed in table 3. It can be seen from table 3 that, compared with the optical filters prepared from the photosensitive resin compositions in the comparative examples 1-2, the optical filters prepared from the photosensitive resin compositions in the examples 5-12 have more excellent sensitivity and resolutions, and particularly, the transmittance is significantly improved. As the change of the transmittance can reflect the heat resistance and the light resistance of the reaction, if the heat resistance is worse, the transmittance will generate a remarkable change after roasting at a high temperature of 230°C. The transmittance of the optical filter of the present invention is better, thus it reflects that the heat resistance and the light resistance of the optical filter are better as well. That is to say, the above results indicate that the optical filter with excellent heat resistance and the light resistance, and high transmittance can be prepared from the photosensitive resin composition comprising the dye compound of the present invention, and the prepared optical filter is free of surface shrinkage.

**Table 3 performance test results of the optical filter**

| Compassion items | Sensitivity (mj/cm²) | Resolution (µm) | Transmittance (%) | Surface shrinkage |
|---|---|---|---|---|
| Example 5 | 150 | 3 | 15 | ○ |
| Example 6 | 150 | 3 | 30 | ○ |
| Example 7 | 150 | 3 | 30 | ○ |
| Example 8 | 150 | 3 | 15 | ○ |
| Example 9 | 150 | 3 | 30 | ○ |
| Example 10 | 150 | 3 | 30 | ○ |
| Example 11 | 150 | 3 | 25 | ○ |
| Example 12 | 150 | 3 | 40 | ○ |
| Comparative Example 1 | 150 | 3 | 20 | × |
| Comparative Example 2 | 150 | 3 | 10 | × |

It can be understood that, the above embodiments are merely exemplary embodiments used for illustrating the principle of the present invention, but the present invention is not limited hereto. Those of ordinary skill in the art can make a variety of modifications and improvements without departing from the spirit and essence of the present invention, and these modifications and improvements shall fall into the protection scope of the present invention.

## Claims

1. A dye compound, comprising a repeat unit shown by Formula 1, a repeat unit shown by Formula 2 and a repeat unit from an olefinic unsaturated monomer having an epoxy functional group;
wherein, the Formula 1 and Formula 2 are as follows: 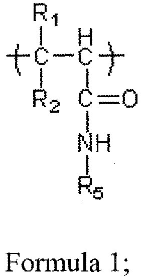 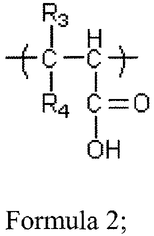 wherein, R₁, R₂, R₃, R₄ and R₅ each independently represent a hydrogen atom; or a straight-chain alkyl, a branched chain alkyl, a cycloalkyl or an aryl having 1-12 carbon atoms; and the dye compound has a molecular weight of 5000-20000.

2. The dye compound of claim 1, wherein the olefinic unsaturated monomer having an epoxy functional group comprises one or more of glycidyl methacrylate, glycidyl acrylate and allyl glycidyl ether.

3. The dye compound of claim 1, wherein the dye compound has a molecular weight of 8000-12000.

4. A method for preparing the dye compound of any one of claims 1-3, comprising the following steps:
1) Preparing an amide compound
reacting an olefinic unsaturated monomer having acyl chloride with an alkaline dye having an amino to obtain the amide compound; and 2) copolymerization
the obtained amide compound, an olefinic unsaturated monomer having an epoxy functional group and an olefinic unsaturated monomer having at least one carboxyl or carboxylic acid anhydride group carrying out copolymerization in a solvent to give the dye compound.

5. The method for preparing the dye compound of claim 4, wherein in the step of preparing an amide compound, a weight ratio of the alkaline dye having an amino to the olefinic unsaturated monomer having acyl chloride is (0.5-4):1.

6. The method for preparing the dye compound of claim 4, wherein in the step of preparing the amide compound, reaction time is 2-5h, and reaction temperature is 0-20°C.

7. The method for preparing the dye compound of claim 4, wherein in the copolymerization step, a weight ratio of the amide compound, the olefinic unsaturated monomer having at least one carboxyl or carboxylic acid anhydride group, the olefinic unsaturated monomer having an epoxy functional group to the solvent is (2-6):(1-5):(1-5):(15-25).

8. The method for preparing the dye compound of claim 4, wherein in the copolymerization step, a ratio of an initiator of copolymerization to the sum of the olefinic unsaturated monomer having an epoxy functional group and the olefinic unsaturated monomer having at least one carboxyl or carboxylic acid anhydride group is 0.5-5%.

9. The method for preparing the dye compound of claim 4, wherein in the copolymerization step, reaction temperature of the copolymerization is 95-105°C, and reaction time is 1-5h.

10. The method for preparing the dye compound of claim 4, wherein the olefinic unsaturated monomer having acyl chloride comprises one or more of acryloyl chloride, methacryloyl chloride, N-hydroxyethyl acryloyl chloride or N-hydroxyethyl methacryloyl chloride.

11. The method for preparing the dye compound of claim 4, wherein the alkaline dye having an amino comprises one or more of basic blue 11, basic blue 17, basic blue 26, basic red 9, basic red 2 and basic violet 2.

12. The method for preparing the dye compound of claim 4, wherein the olefinic unsaturated monomer having an epoxy functional group comprises one or more of glycidyl methacrylate, glycidyl acrylate and allyl glycidyl ether.

13. The method for preparing the dye compound of claim 4, wherein the olefinic unsaturated monomer having at least one carboxyl or carboxylic acid anhydride group comprises a monocarboxylic acid having a vinyl group and an anhydride thereof, a dicarboxylic acid having a vinyl group and an anhydride thereof, a polycarboxylic acid having a vinyl group and an anhydride thereof.

14. The method for preparing the dye compound of claim 13, wherein the monocarboxylic acid having a vinyl group and the anhydride thereof include any one of acrylic acid, methacrylic acid, crotonic acid, α-chloroacrylic acid, cinnamic acid, and anhydrides thereof; and
the dicarboxylic acid having a vinyl group comprises any one of maleic acid, fumaric acid, itaconic acid, the citraconic acid, and anhydrides thereof.

15. A colorant, comprising the dye compound of any one of claims 1-3.

16. The colorant of claim 15, wherein the colorant comprises:
5-50 parts by weight of the dye compound; and
5-50 parts by weight of pigment.

17. A photosensitive resin composition, comprising the dye compound of any one of claims 1-3.

18. The photosensitive resin composition of claim 17, wherein the photosensitive resin composition further comprises a pigment dispersion.

19. The photosensitive resin composition of claim 18, wherein the photosensitive resin composition comprises:
5-50 parts by weight of the dye compound;
5-50 parts by weight of a pigment dispersion;
5-60 parts by weight of an alkaline soluble resin;
5-60 parts by weight of a polymerizable monomer;
0.1-10 parts by weight of a photopolymerization initiator; and
100-3000 parts by weight of a solvent.

20. An optical filter, prepared from the photosensitive resin composition of any one of claims 17-19.
